# EUROPEAN PATENT SPECIFICATION

(11) **EP 2 479 151 B1**
(45) Date of publication and mention of the grant of the patent: **28.10.2020**
(21) Application number: 10817147.1
(22) Date of filing: 14.09.2010
(51) Int. Cl.: B32B 17/06, B32B 7/06, C03C 17/34, H01L 51/52

(54) **METHOD FOR PRODUCING GLASS FILM, METHOD FOR PROCESSING GLASS FILM, AND GLASS FILM LAMINATE**
VERFAHREN ZUR HERSTELLUNG EINES GLASFILMS, VERFAHREN ZUR VERARBEITUNG EINES GLASFILMS UND GLASFILMLAMINAT
PROCÉDÉ DE FABRICATION D'UN FILM DE VERRE, PROCÉDÉ DE TRAITEMENT DU FILM DE VERRE ET LAMINÉ DE FILM DE VERRE

(30) Priority: 18.09.2009 JP 2009217448; 12.02.2010 JP 2010028737
(43) Date of publication of application: 25.07.2012
(73) Proprietor: Nippon Electric Glass Co., Ltd., Otsu-shi Shiga 520-8639 (JP)
(72) Inventor: TOMAMOTO Masahiro, Otsu-shi Shiga 520-8639 (JP); TAKAYA Tatsuya, Otsu-shi Shiga 520-8639 (JP); TAKIMOTO Hiroshi, Otsu-shi Shiga 520-8639 (JP); ORIGUCHI Nagatoshi, Otsu-shi Shiga 520-8639 (JP)
(74) Representative: Tetzner, Michael
(86) International application number: PCT/JP2010/065778
(87) International publication number: WO 2011/034034

(56) References cited:
- JP-A- 6 043 445
- JP-A- 8 165 133
- JP-A- 8 231 233
- JP-A- H09 221 342
- JP-A- 2001 097 733
- US-A1- 2005 136 625
- US-A1- 2008 309 867

## Description

### Technical Field

The present invention relates to a method of producing a glass film which is used for a flat panel display such as a liquid crystal display and an OLED display, a glass substrate for devices such as a solar cell, a lithium ion battery, a digital signage, a touch panel, and an electronic paper, a cover glass for devices such as an OLED lighting device, a package for a medicinal product, and the like, and relates to a glass film laminate which is supported with a supporting glass.

### Background Art

From the viewpoint of space saving, in recent years, there have been widely used flat panel displays such as a liquid crystal display, a plasma display, an OLED display, and a field emission display, in place of a CRT type display conventionally and widely used. Further reduction in thickness is demanded for those flat panel displays. In particular, it is required that the OLED display be easily carried by being folded or wound and be usable not only on a flat surface but also on a curved surface. Further, it is not just displays that are required to be usable not only on a flat surface but also on a curved surface. For example, if a solar cell or an OLED lighting device can be formed on a surface of an object having a curved surface, such as a surface of an automobile body, or a roof, a pillar, or an outer wall of a building, the applications of the solar cell or OLED lighting device may expand. Substrates and cover glasses used for those devices are required to be thinner and to have higher flexibility.

A light-emitting element used for an OLED display deteriorates in quality through the contact of gasses such as oxygen or water vapor. Thus, a substrate used for the OLED display is required to have high gas-barrier property, and hence the use of a glass substrate for the substrate is expected. However, glass used for a substrate is weak in tensile stress unlike a resin film, and hence is low in flexibility. Thus, application of a tensile stress on a surface of a glass substrate by bending the glass substrate leads to the breakage of the glass substrate. In order to impart flexibility to the glass substrate, the glass substrate is required to achieve an ultra thin sheet. Thus, there is proposed a glass film having a thickness of 200 µm or less as described in JP 2008 133174 A.

A glass substrate used for electronic devices such as a flat panel display or a solar cell is subjected to various electronic device production-related treatments, such as processing treatment or cleaning treatment. However, when a glass film is used as a glass substrate for those electronic devices, the glass film breaks due to a stress change even at a small amount, because glass is a brittle material. Thus, there is a problem in that the handling of the glass film is very difficult, when the above-mentioned various electronic device production-related treatments are carried out. In addition, there is another problem in that a glass film having a thickness of 200 µm or less is rich in flexibility, and hence the positioning of the glass film is difficult when the treatment is carried out, and displacement or the like in patterning may occur.

In order to enhance handling easiness of a glass film, a laminate described in JP 08 86993 A is proposed. JP 08 86993 A proposes a laminate in which a supporting glass and a glass sheet are laminated via a pressure-sensitive adhesive layer whose property is maintained almost stably even after its repeated use. According to this, even if a glass sheet poor in strength and rigidity as a single product is used, the production of a liquid crystal display device may be carried out with a conventional line for producing a liquid crystal display device using glass. Thus, after the completion of the processes, peeling off from the supporting glass can be carried out quickly without the breakage of the glass sheet. In addition, problems such as displacement hardly occur when the positioning is carried out during the treatment, because the support glass has a high rigidity.

US 2008/0309867 A1 discloses a method of fabricating of a screen type thin-film flexible electronic device that includes a plurality of thin-film components on a glass support, wherein a starting support is prepared, including a rigid bulk substrate and a glass sheet fastened to the rigid bulk substrate by reversible direct bonding so as to obtain a removable interface, and an oxide layer, such as SiO₂, is deposited onto one of the glass layers before bonding.

### Summary of Invention

### Technical Problem

However, the above-mentioned various production-related treatments include a treatment involving heating step, such as forming treatment for a transparent conductive film or sealing treatment. A pressure-sensitive adhesive layer is inferior in heat resistance. Thus, when the treatment involving heating is carried out, the pressure-sensitive adhesive layer may deposit to lead to contamination of a glass film.

Further, it is conceivable to use, for example, a setter for sintering made of a crystallized glass or the like for supporting a glass film without using a pressure-sensitive adhesive layer. However, the glass film may slip on the setter, and hence there occurs again a problem that positioning is difficult to carry out at the time of treatment.

Thus, it was not possible conventionally that a glass film was able to be easily peeled off in a clean state after subjecting to a treatment involving heating, while the glass film was able to be supported to be positioned properly without slipping on a surface of a supporting member.

The present invention has been made to solve the above-mentioned problems with prior art. An object of the present invention is to enhance the handling easiness of a glass film and enable the proper positioning of the glass film when the glass film is subjected to the device production-related treatment or the like, to enable easy peeling off the glass film from a supporting glass particularly when the glass film is incorporated into each of various devices after the treatment involving heating, and to securely prevent a pressure-sensitive adhesive or the like from remaining on the glass film after the peeling off, to thereby obtain a clean glass film.

### Solution to Problem

The inventors of the present invention have found that when two glass substrates each having an Ra of 2.0 nm or less are attached with each other and the attached surfaces of both the glass substrates are heated, the glass substrates adhere with each other. The inventors have also found that when an inorganic thin film is formed on one of glass substrates, the glass substrates do not adhere with each other even when heating is performed. The inventors have further found that when the surface roughness of the inorganic thin film is made small, both the glass substrates attach to each other via the inorganic thin film but do not adhere with each other even when the treatment involving heating is carried out, and hence both the glass substrates can be easily peeled off after the heating. As a result, the inventors have reached the present invention.

The invention of the present application relates to a method of producing a glass film, comprising a first step of forming an inorganic thin film on a surface of a supporting glass so that a surface of the inorganic thin film after being formed has a surface roughness Ra of 2.0 nm or less, the inorganic thin film being formed of at least one inorganic materials selected from ITO, Ti, Au, Ag, Al, Cr, Cu, Mg, Ti, Al₂O₃, MgO, Y₂O₃, La₂O₃, Pr₆O₁₁, Ss₂O₃, WO₃, HfO₂, In₂O₃, ZrO₂, Nd₂O₃, Ta₂O₅, CeO₂, Nb₂O₅, TiO, TiO₂, Ti₃O₅, NiO, and ZnO, a second step of forming a glass film laminate by laminating a glass film having a surface roughness Ra of 2.0 nm or less on the surface of the inorganic thin film in a state of being in contact with each other, a third step of carrying out treatment involving heating with respect to the glass film laminate, and a fourth step of peeling off the glass film from the supporting glass after the treatment involving heating.

In the present invention, it is preferred that the inorganic thin film include an oxide thin film.

Further, in the present invention, it may take such a configuration that the glass film and the supporting glass are laminated so that at least a part of an edge portion includes a step.

Further, a method of treating a glass film comprises a first step of forming an inorganic thin film on the surface of a supporting glass so that a surface of the inorganic thin film after being formed has a surface roughness Ra of 2.0 nm or less, a second step of forming a glass film laminate by laminating a glass film having a surface roughness Ra of 2.0 nm or less on the surface of the inorganic thin film in a state of being in contact with each other, a third step of carrying out treatment involving heating with respect to the glass film laminate, and a fourth step of peeling off the glass film from the supporting glass after the treatment involving heating.

Further, the present invention relates to a glass film laminate comprising a supporting glass and a glass film laminated on the supporting glass, wherein an inorganic thin film is formed on a surface, on which the glass film is laminated, of the supporting glass so that a surface of the inorganic thin film after being formed has a surface roughness Ra of 2.0 nm or less, the inorganic thin film being formed of at least one inorganic materials selected from ITO, Ti, Au, Ag, Al, Cr, Cu, Mg, Ti, Al₂O₃, MgO, Y₂O₃, La₂O₃, Pr₆O₁₁, Ss₂O₃, WO₃, HfO₂, In₂O₃, ZrO₂, Nd₂O₃, Ta₂O₅, CeO₂, Nb₂O₅, TiO, TiO₂, Ti₃O₅, NiO, and ZnO, the glass film has a surface roughness Ra of 2.0 nm or less at least at a surface of a laminate side, and the glass film is laminated on the inorganic thin film in a state of the surface of the inorganic thin film and the surface of the glass film being in contact with each other.

In the present invention, it is preferred that each of the surface of the laminate side of the glass film and the surface of the inorganic thin film has a GI value of 1000 pcs/m² or less. Further, it is preferred that the glass film have a thickness of 300 µm or less and that the supporting glass have a thickness of 400 µm or more. Further, it is preferred that a difference in thermal expansion coefficients between the glass film and the supporting glass at 30 to 380°C fall within 5×10⁻⁷/°C.

The glass film and the supporting glass in the present invention are preferably formed by an overflow down-draw method respectively.

### Advantageous Effects of Invention

According to the present invention, the glass film laminate is formed by laminating the glass film having a surface roughness Ra of 2.0 nm or less on the surface of the inorganic thin film having a surface roughness Ra of 2.0 nm or less formed on the surface of the supporting glass in a state of being in contact with each other, resulting in good contactness between the glass film and the inorganic thin film. Thus, it is possible to fix and laminate the glass film and the supporting glass via the inorganic thin film without use of a pressure-sensitive adhesive. As a result, the glass film is not displaced with respect to the supporting glass during the device production-related treatment or the like, and hence the glass film can be positioned at a correct position. Further, the glass film does not adhere to the inorganic thin film even when the glass film is subjected to heating, and hence the glass film can be easily peeled off from the supporting glass (inorganic thin film) after the treatment. Moreover, after being peeled off, the glass film results in a clean one without adhesion of a pressure-sensitive adhesive or the like.

On the other hand, when the surface roughnesses Ra of the inorganic thin film and glass film exceed 2.0 nm, the contactness between the both glasses lowers. As a result, the glass film and the supporting glass cannot be firmly fixed and laminated without a pressure-sensitive adhesive.

When an oxide thin film is adopted as the above-mentioned inorganic thin film, the glass film and the supporting glass can be more stably fixed and laminated.

Further, by laminating the glass film and the supporting glass so that at least a part of an edge portion includes a step, in a case of the glass film protruding from the supporting glass, it is possible to peel off the glass film and the supporting glass more easily in a more secure manner. On the other hand, in a case of the supporting glass protruding from the glass film, it is possible to properly protect an end portion of the glass film from striking or the like.

The glass film laminate of the present invention formed by laminating the supporting glass and the glass film via the inorganic thin film has better handling easiness compared with a glass film as a single member. Further, even after the glass film laminate is subjected to the device production-related treatment involving heating or the like, the glass film can be easily peeled off from the supporting glass. In addition, a pressure-sensitive adhesive or the like is not used, and hence, after the glass film is peeled off, the glass film is without adhesion of the pressure-sensitive adhesive or the like and is clean.

By setting the GI value of each of the surface of the inorganic thin film and the surface of the laminate side of the glass film to 1000 pcs/m² or less, the glass film and the supporting glass can be laminated and fixed more firmly.

The present invention is suitable for the production and the treatment of an ultrathin glass film that is more difficult to handle due to its thickness of 300 µm or less. Further, by setting a thickness of a supporting glass to 400 µm or more, the glass film can be securely supported.

Further, by controlling the difference in thermal expansion coefficients between the glass film and the supporting glass at 30 to 380°C within 5×10⁻⁷/°C, it is possible to form a glass film laminate in which thermal warpage or the like hardly occurs, even when the treatment involving heating is carried out.

By forming the glass film and the supporting glass in the present invention by the overflow down-draw method, the glass film and the supporting glass have extremely high surface precision without being subjected to a polishing step. As a result, an inorganic thin film high in surface precision can be easily formed on the surface of the supporting glass.

### Brief Description of Drawings

[Fig. 1] Fig. 1 is a cross-sectional view of a glass film laminate according to the present invention.
[Fig. 2] Fig. 2 is an explanatory diagram of a manufacturing apparatus for a glass film and a supporting glass.
[Fig. 3(a)] Fig. 3(a) is a view of a glass film laminate in which a glass film and a supporting glass are laminated with a step at an edge portion of the glass film laminate, for illustrating a configuration in which the supporting glass protrudes from the glass film.
[Fig. 3(b)] Fig. 3(b) is a view of a glass film laminate in which a glass film and a supporting glass are laminated with a step at an edge portion of the glass film laminate, for illustrating a configuration in which the glass film protrudes from the supporting glass.
[Fig. 3(c)] Fig. 3(c) is a view illustrating a configuration in which a notch portion is formed in a supporting glass.
[Fig. 4] Fig. 4 is a schematic diagram of a method of producing a glass film according to the present invention.

### Description of Embodiments

Hereinafter, a preferred embodiment of a method of producing a glass film according to the present invention is described with reference to the drawings.

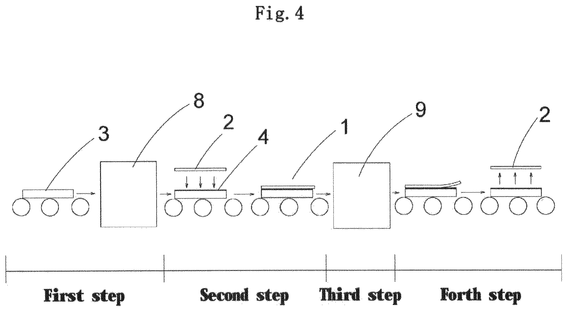

The method of producing a glass film according to the present invention includes, as shown in Fig. 4, a first step of forming an inorganic thin film (4) on a surface of a supporting glass (3) by film formation means (8) so that the inorganic thin film (4) has a surface roughness Ra of 2.0 nm or less after the film formation, a second step of forming a glass film laminate (1) by laminating a glass film (2) having a surface roughness Ra of 2.0 nm or less on the surface of the inorganic thin film (4) in a state of being in contact with each other, a third step of carrying out treatment involving heating with respect to the glass film laminate (1) by treatment means (9), and a fourth step of peeling off the glass film (2) from the supporting glass (3) after the treatment involving heating.

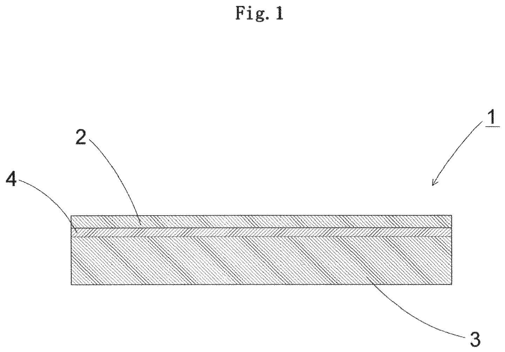

Fig. 1 shows a glass film laminate (1) that is manufactured through the second step described above. An inorganic thin film (4) is formed on a surface of a supporting glass (3), and a glass film (2) is laminated and fixed on the surface of the inorganic thin film (4) in a state of being directly in contact with the surface of the inorganic thin film (4).

For the glass film (2), silicate glass is used, silica glass or borosilicate glass is preferably used, or alkali-free glass is most preferably used. If the glass film (2) contains an alkali component, a cation is detached from a surface of the glass film, leading to occurrence of a so-called too-abundant soda phenomenon and resulting in a coarse structure. In this case, if the glass film (2) is continuously used in a bent state, the glass film (2) may break at a portion whose structure has become course because of aging degradation. Note that the alkali-free glass is glass substantially free of an alkali component (alkali metal oxide), and specifically, glass that contains the alkali of 1000 ppm or less. The content of the alkali component in the present invention is preferably 500 ppm or less, more preferably 300 ppm or less.

The glass film (2) has a thickness of preferably 300 µm or less, more preferably 5 µm to 200 µm, most preferably 5 µm to 100 µm. With this, a thickness of the glass film (2) may be made thinner to impart an appropriate flexibility to the glass film (2). Further, in this case, the device production-related treatment or the like can be easily carried out with respect to the glass film (2), which is hard to handle and easily causes problems such as a positioning error and displacement in patterning. When the thickness of the glass film (2) is less than 5 µm, the glass film (2) tends to have insufficient strength. As a result, when the glass film (2) is peeled off from the glass film laminate (1) to be incorporated into a device, the glass film (2) becomes liable to cause a breakage.

For the supporting glass (3), similar to the glass film (2), silicate glass, silica glass, borosilicate glass, or alkali-free glass, or the like is used. The supporting glass (3) is preferably made of glass having a difference in thermal expansion coefficients between the glass film (2) and the supporting glass (3) at 30 to 380°C of within 5×10⁻⁷/°C. With this, there can be provided the glass film laminate (1) in which thermal warpage or the like is not easily caused by the difference in thermal expansion coefficients even when heat treatment is carried out during the production-related treatment, and a stable laminated state can be maintained. For the supporting glass (3) and glass film (2), it is most preferred that glasses each having the same composition be used.

The supporting glass (3) preferably has a thickness of 400 µm or more. This is because when the supporting glass (3) has a thickness of less than 400 µm, the supporting glass (3) may have a problem in strength when being used as a single member. The supporting glass (3) preferably has a thickness of 400 µm to 700 µm, most preferably 500 µm to 700 µm. With this, the glass film (2) can be securely supported, and it becomes possible to effectively suppress a breakage that may occur when the glass film (2) is peeled off from the supporting glass (3). Note that when the glass film laminate (1) is placed on a setter not shown, the supporting glass (3) may have a thickness of less than 400 µm.

The first step described above is a step of forming an inorganic thin film (4) on a surface of a supporting glass (3) so that the inorganic thin film (4) has a surface roughness Ra of 2.0 nm or less after the film formation. As the inorganic thin film (4) is formed on the surface of the supporting glass (3), the adhesion of the supporting glass (3) and a glass film (2) can be prevented even when the treatment involving heating such as heat treatment is carried out. Further, as the inorganic thin film (4) has a surface roughness Ra of 2.0 nm or less, the glass film (2) can be laminated and fixed in a state of being in contact with the surface of the inorganic thin film (4) without use of a pressure-sensitive adhesive or the like.

The surface roughness Ra of the inorganic thin film (4) formed on the supporting glass (3) is preferably 1.0 nm or less, more preferably 0.5 nm or less, most preferably 0.2 nm or less.

If the inorganic thin film (4) can be formed so as to have a surface roughness Ra of 2.0 nm or less, the surface roughness Ra of the supporting glass (3) is not particularly limited. However, if the surface of the supporting glass (3) is coarse, the unevenness of the surface of the supporting glass (3) affects the inorganic thin film (4) after its formation. As a result, it may be difficult to form an inorganic thin film (4) having a surface roughness Ra of 2.0 nm or less. Thus, the surface roughness Ra of the supporting glass (3) is preferably 2.0 nm or less, more preferably 1.0 nm or less, still more preferably 0.5 nm or less, most preferably 0.2 nm or less.

The thickness of the inorganic thin film (4) is preferably 1 nm to 10000 nm. In order to suppress the cost of film formation, a smaller thickness is more advantageous. Thus, the thickness of the inorganic thin film (4) is more preferably 1 nm to 1000 nm, most preferably 1 nm to 200 nm.

The inorganic thin film (4) is formed of one kind or two or more kinds selected from ITO, Ti, Au, Ag, Al, Cr, Cu, Mg, Ti, Al₂O₃, MgO, Y₂O₃, La₂O₃, Pr₆O₁₁, Sc₂O₃, WO₃, HfO₂, In₂O₃, ZrO₂, Nd₂O₃, Ta₂O₅, CeO₂, Nb₂O₅, TiO, TiO₂, Ti₃O₅, NiO, and ZnO.

The inorganic thin film (4) is more preferably an oxide thin film. The oxide thin film is thermally stable, and hence formation of the oxide thin film on a supporting glass enables repeated use of the supporting glass (3) with the thin film even when the treatment involving heating is carried out with respect to the glass film laminate (1). Preferably used for the oxide thin film is Al₂O₃, MgO, Y₂O₃, La₂O₃, Pr₆O₁₁, Ss₂O₃, WO₃, HfO₂, In₂O₃, ITO, ZrO₂, Nd₂O₃, Ta₂O₅, CeO₂, Nb₂O₅, TiO, TiO₂, Ti₃O₅, NiO, ZnO, or a combination thereof.

In Fig. 1, only one layer of the inorganic thin film (4) is formed on the supporting glass (3). However, the inorganic thin film (4) may be formed by a plurality of layers. In this case, the outermost layer (a layer being in contact with the glass film (2)) is preferably an oxide thin film, because the oxide thin film is, as described above, thermally stable.

In Fig. 1, an inorganic thin film (4) is formed only on the surface, on which the glass film (2) is laminated, of the supporting glass (3). However, in order to make both the surfaces of the supporting glass (3) usable, another inorganic thin film (4) may be formed on the surface opposite to the above-mentioned surface. In addition, an inorganic thin film (4) may be formed on the whole surface of the supporting glass (3).

In the first step described above, any known method may be used as the film formation means (8) shown in Fig. 4. A sputtering method, a vapor deposition method, a CVD method, a sol-gel method, or the like may be used.

The second step described above is a step of forming the glass film laminate (1) shown in Fig. 1 by laminating a glass film (2) having a surface roughness Ra of 2.0 nm or less on the surface of the inorganic thin film (4) in a state of being in contact with each other.

Both the surface roughness Ra of the surface of the inorganic thin film (4) and that of the surface of the laminate side of the glass film (2) are 2.0 nm or less. If Ra exceeds 2.0 nm, the contactness between the glass film (2) and the inorganic thin film (4) on the supporting glass (3) lowers. As a result, it is not possible to laminate and fix firmly the glass film (2) and the inorganic thin film (4) on the supporting glass (3) without adhesive. The surface roughness Ra of the glass film (2) is preferably 1.0 nm or less, more preferably 0.5 nm or less, most preferably 0.2 nm or less.

The GI value of the surface of the laminate side of the glass film (2) and that of the surface of the inorganic thin film (4) on the supporting glass (3) are each preferably 1000 pcs/m² or less. With this, the surface of the laminate side of the glass film (2) and the surface of the inorganic thin film (4) on the supporting glass (3) are clean to be without loss of the activities of the surfaces. As a result, it is possible to laminate and fix more firmly and stably the glass film (2) and the inorganic thin film (4) on the supporting glass (3) without use of an adhesive. In the present specification, the GI value refers to a number (pcs) of impure particles each having a major diameter of 1 µm or more and existing in a region of 1 m². The GI value of the surface of the laminate side of the glass film (2) and that of the surface of the inorganic thin film (4) on the supporting glass (3) are each preferably 500 pcs/m² or less, most preferably 100 pcs/m² or less.

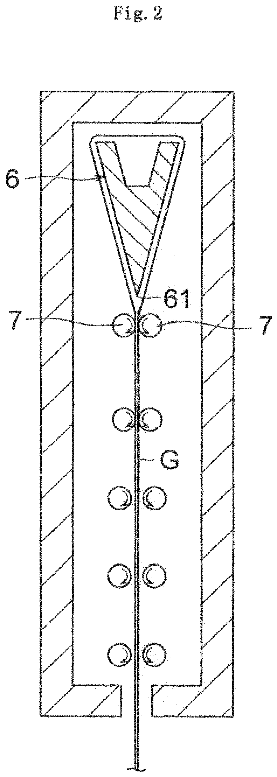

The glass film (2) and the supporting glass (3) to be used in the present invention are preferably formed by a down-draw method. This is because the glass film (2) and the supporting glass (3) can be each formed so as to have a smoother surface. In particular, the overflow down-draw method shown in Fig. 2 is a forming method in which both surfaces of a glass sheet are not brought into contact with a forming member during formation, and hence flaws are hardly caused on both the surfaces (translucent surfaces) of the obtained glass sheet, and high surface-quality may be obtained without polishing.

In the overflow down-draw method shown in Fig. 2, a glass ribbon (G) immediately after flowing down from a lower end portion (61) of a forming body (6) having a wedge shape in its cross-section is drawn downwardly with a cooling roller (7) with its shrinkage in a width direction being restricted, resulting in a thin ribbon having a predetermined thickness. Subsequently, the glass ribbon (G) having the predetermined thickness is gradually annealed in an annealer to remove heat strain in the glass ribbon (G), followed by cutting of the glass ribbon (G) into pieces having a predetermined size. As a result, the glass film (2) and the supporting glass (3) are formed.

The third step described above is a step of carrying out the treatment involving heating by treatment means (9) with respect to the glass film laminate (1) manufactured in the second step.

Examples of the treatment involving heating in the third step includes film formation treatment by a sputtering method or the like, sealing treatment for sealing a element or the like, and treatment for sintering a glass frit, in a device production, particularly in an electronic device production. Further, there is exemplified the film formation treatment such as formation of an antireflective film or an anti-transmission film by a sputtering method or the like, in the production of a glass film.

The treatment means (9) used in the third step may be formed by single treatment means or may be formed by a plurality of the same treatment means or a plurality of different treatment means.

The fourth step described above is a step of peeling off the glass film (2) from the supporting glass (3) after the third step. As the inorganic thin film (4) is formed on the surface of the supporting glass (3) through the first step, the adhesion of the supporting glass (3) and the glass film (2) can be prevented even when the production-related treatment involving heating is carried out in the third step, and hence the glass film (2) can be easily peeled off. Note that when the glass film (2) is incorporated into each of various devices after the device production-related treatment, if the glass film (2) can be peeled off from the supporting glass (3) even at one portion, then the whole glass film (2) can be easily peeled off sequentially from the supporting glass (3). Further, the glass film (2) after being peeled off is a clean one which is completely free of a pressure-sensitive adhesive or the like.

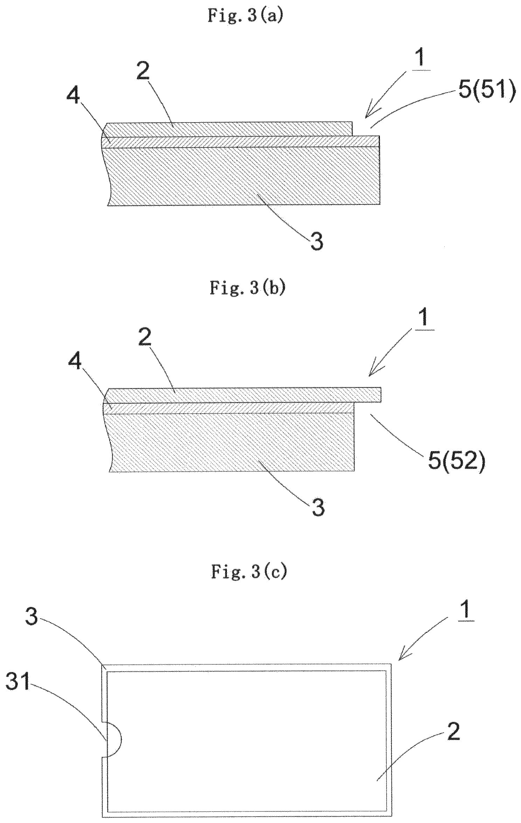

The glass film laminate (1) manufactured through the second step described above preferably has a structure in which, as shown in Figs. 3(a) to 3(c), the glass film (2) and the supporting glass (3) are laminated with a step (5) at its edge portion. In the configuration shown in Fig. 3(a), a step (51) is formed so that the supporting glass (3) protrudes from the glass film (2). With this, the end portion of the glass film (2) can be protected more appropriately. On the other hand, in the configuration shown in Fig. 3(b), a step (52) is formed under a state in which the glass film (2) protrudes from the supporting glass (3). With this, when peeling off of the glass film (2) and the supporting glass (3) is started, only the glass film (2) can easily be grasped, and hence peeling off of both can be performed more easily in a more secure manner. In the configuration shown in Fig. 3(c), a notch portion is formed at an edge portion of the supporting glass (3).

The step (5) may only be formed at least at a part of the peripheral portion of the glass film laminate (1). For example, when the glass film laminate (1) has a rectangular shape in a planar view, the step (5) may only be formed at least on one side out of the four sides. Further, a notch (orientation flat) may be formed at a part of one of the four corners of the supporting glass (3) or the glass film (2), to thereby form a step.

In the configuration shown in Fig. 3(b), the protruded length of the glass film (3) is preferably 1 mm to 20 mm. If the protruded length is less than 1 mm, there is a possibility of becoming hard to grasp the edge portion of the glass film (2) at the time of the start of peeling off, and if the protruded length exceeds 20 mm, there is a possibility of causing a breakage of the glass film (2) when an external force such as striking is applied to the side edge of the glass film laminate (1).

In addition, the glass film laminate (1) may be formed with both steps at the end portion thereof, wherein one step (5) is formed by protruding the edge portion of the supporting glass (3) from the edge portion of the glass film (2), and the other step (5) is formed by protruding the edge portion of the glass film (2) from the edge portion of the supporting glass (3). As a result, each of the glass film (2) and the supporting glass (3) can be grasped at the same time, and the glass film (2) can be peeled off more easily. Both the steps above are most preferably formed adjacently to each other.

In addition, as shown in Fig. 3(c), in a case where the size of the glass film (2) is smaller than the size of the supporting glass (3), a notch portion (31) is preferably formed at an end portion of the supporting glass (3). As a result, besides appropriately protecting the end portion of the glass film (2), when peeling off of the glass film (2), the glass film (2) can be easily grasped at a portion which is exposed from the notch portion (31), thereby being capable of easily peeling off the glass film (2). The notch portion (31) can be formed by partially grinding a part of an end portion of the supporting glass (3) with a grinding stone or the like, or by partially cutting out a part of an end portion of the supporting glass (3) with a core drill or the like.

In the method of producing a glass film according to the present invention, the first step, the second step, the third step, and the fourth step, each schematically shown in Fig. 4, can be carried out sequentially. As the supporting glass (3) can be reused, the first step includes the introduction of a supporting glass (3) on which the inorganic thin film (4) has already been formed into a line just before the second step. Further, the method of producing a glass film is not limited to the configuration in which the steps from the first step to the fourth step are carried out sequentially, and may be, for example, a configuration in which a glass film laminate (1) after the second step is packed and delivered to a different facility for production-related treatment, in which the third step and the fourth step are carried out.

### Example 1

Hereinafter, the method of producing a glass film of the present invention is described in detail based on examples, but the present invention is not limited to those examples.

### (Lamination test)

A transparent glass sheet having a rectangular shape and having 250 mm in length, 250 mm in width, and 700 µm in thickness was used as a supporting glass. A glass film having 230 mm in length, 230 mm in width, and 100 µm in thickness was used as a glass film to be laminated on the supporting glass. Used for the supporting glass and the glass film was alkali-free glass manufactured by Nippon Electric Glass Co., Ltd. (Production name: OA-10G, thermal expansion coefficient at 30 to 380°C: 38×10⁻⁷/°C). The glass formed by the overflow down-draw method was used without polishing as it is, or by appropriately controlling amounts of polishing and chemical etching, to thereby control the surface roughness Ra. As shown in Table 1, ITO and Ti were each formed into an inorganic thin film each having a thickness of 50 to 200 nm on the supporting glass. The film formation was carried out by using an inline sputtering apparatus manufactured by BOC. Next, the surface roughness Ra on each of the surfaces of the inorganic thin film on the supporting glass and of the laminate side of the glass film was measured by using an AFM (Nanoscope III a) manufactured by Veeco Instruments under the conditions of a scan size of 10 µm, a scan rate of 1 Hz, and 512 sample lines. The surface roughness Ra was determined from measured values within a 10 µm square measurement range. After the measurement, each of the supporting glasses and the glass films were divided into test groups shown in Table 1.

After that, in accordance with the each division shown in Table 1, the glass film was laminated directly on the surface of the inorganic thin film on the supporting glass. "o" is marked for a case where the supporting glass and the glass film were firmly attached and their lamination was possible. "×" is marked for a case where the supporting glass and the glass film were not attached. The above-mentioned criteria were used to make determinations. Table 1 shows the results.

**[Table 1]**

| ITO | Example 1 | Example 2 | Example 3 | Comparative Example 1 | Comparative Example 2 |
|---|---|---|---|---|---|
| Glass film Ra (nm) | 0.5 | 1.0 | 2.0 | 0.5 | 1.0 |
| Inorganic thin film Ra (nm) | 0.5 | 1.3 | 1.5 | 2.3 | 2.4 |
| Thickness of inorganic thin film formed (nm) | 50 | 80 | 100 | 150 | 200 |
| Determination result | ○ | ○ | ○ | × | × |
| | | | | | |

| Ti | Example 4 | Example 5 | Example 6 | Example 7 | Comparative Example 3 |
|---|---|---|---|---|---|
| Glass film Ra (nm) | 2.0 | 1.5 | 1.0 | 0.5 | 1.0 |
| Inorganic thin film Ra (nm) | 0.7 | 0.7 | 1.3 | 2.0 | 2.6 |
| Thickness of inorganic thin film formed (nm) | 50 | 80 | 100 | 150 | 200 |
| Determination result | ○ | ○ | ○ | ○ | × |

As shown in Table 1, in Examples 1 to 7 in each of which the glass film and inorganic thin film each have a surface roughness Ra of 2.0 nm or less, the glass film and the inorganic thin film on the supporting glass have sufficient contactness, and hence it is found that the glass film and inorganic thin film can be firmly laminated and fixed. Contrary to this, in Comparative Examples 1 to 3 in each of which the surface roughness Ra of the inorganic thin film on the supporting glass exceeds 2.0 nm, as the contacting surfaces is coarse, and hence the contactness between the glass film and the supporting glass is low, which shows that the glass film and inorganic thin film cannot be firmly laminated.

### (Peeling off test)

The same supporting glass and glass film as those used in the lamination test described above were used. As shown in Table 2, inorganic thin films were each formed on the supporting glass by using SiO₂ and Nb₂O₃ in addition to ITO and Ti. There were used the same film formation method and the same measurement method for a surface roughness Ra after the film formation as those used in the lamination test described above. After that, in accordance with the each division shown in Table 2, the glass film was laminated directly on the surface of the inorganic thin film on the supporting glass, to thereby obtain the glass film laminates of Examples 8 to 11. A glass film laminate obtained by laminating a glass film on a supporting glass on which inorganic thin film had not been formed was defined as Comparative Example 4. The lamination states of the glass film laminates of Examples 8 to 11 and Comparative Example 4 were checked. As a result, in each of the glass film laminates, the supporting glass and the glass film were attached firmly, and hence lamination was possible.

Next, the laminates of Examples 8 to 11 and Comparative Example 4 were each subjected to heat treatment by heating at 400°C for 15 minutes. Note that the heat treatment was carried out by using an electric muffle furnace (KM-420) manufactured by ADVANTEC Co., Ltd. The laminates of Examples 8 to 11 and Comparative Example 4 after the heat treatment were used to attempt the peeling off of the supporting glass and the glass film. "o" is marked for a glass film laminate in which the supporting glass and the glass film were able to be peeled off. "×" is marked for a glass film laminate in which the supporting glass and the glass film were unable to be peeled off and the glass film was broken during peeling off. The glass film laminates were determined based on the above-mentioned criteria. Table 2 shows the results.

**[Table 2]**

| | Example 8 | Example 9 | Example 10 | Example 11 | Comparative Example 4 |
|---|---|---|---|---|---|
| Glass film Ra (nm) | 1.0 | 1.0 | 1.0 | 1.0 | 1.0 |
| Supporting glass Ra (nm) | - | - | - | - | 1.0 |
| Type of inorganic thin film | SiO₂ | Nb₂O₃ | ITO | Ti | - |
| Inorganic thin film Ra (nm) | 0.2 | 0.2 | 1.2 | 1.3 | - |
| Thickness of inorganic thin film formed (nm) | 50 | 150 | 100 | 100 | - |
| Determination result | ○ | ○ | ○ | ○ | × |

Table 2 shows that, in Examples 8 to 11 in each of which the inorganic thin film is formed on the supporting glass, the glass film and the supporting glass can be peeled off satisfactorily even after the heat treatment is carried out. In contrast, it is found that, in Comparative Example 4 in which the inorganic thin film is not formed on the supporting glass, the glass film and the supporting glass adhere with each other after the heat treatment, and hence the glass film and the supporting glass cannot be peeled off.

### Industrial Applicability

The present invention can be suitably used for a glass substrate used for devices such as a flat panel display including a liquid crystal display and an OLED display and a solar cell and for a cover glass for an OLED lighting device.

### Reference Signs List

- 1: glass film laminate
- 2: glass film
- 3: supporting glass
- 4: inorganic thin film
- 5: step
- 8: film formation means
- 9: treatment means involving heating

## Claims

1. A method of producing a glass film, comprising:
a first step of forming an inorganic thin film (4) on a surface of a supporting glass (3) so that a surface of the inorganic thin film (4) after being formed has a surface roughness Ra of 2.0 nm or less, the inorganic thin film (4) being formed of at least one inorganic materials selected from ITO, Ti, Au, Ag, Al, Cr, Cu, Mg, Ti, Al₂O₃, MgO, Y₂O₃, La₂O₃, Pr₆O₁₁, Ss₂O₃, WO₃, HfO₂, In₂O₃, ZrO₂, Nd₂O₃, Ta₂O₅, CeO₂, Nb₂O₅, TiO, TiO₂, Ti₃O₅, NiO, and ZnO;
a second step of forming a glass film laminate (1) by laminating a glass film (2) having a surface roughness Ra of 2.0 nm or less on the surface of the inorganic thin film (4) in a state of being in contact with each other;
a third step of carrying out treatment involving heating with respect to the glass film laminate (1); and
a fourth step of peeling off the glass film (2) from the supporting glass (3) after the treatment involving heating.

2. The method of producing a glass film according to claim 1, wherein the glass film (2) and the supporting glass (3) are laminated so that at least a part of an edge portion includes a step (5).

3. A glass film laminate (1) comprising a supporting glass (3) and a glass film (2) laminated on the supporting glass (3), wherein
an inorganic thin (4) film is formed on a surface, on which the glass film (2) is laminated, of the supporting glass (3) so that a surface of the inorganic thin film (4) after being formed has a surface roughness Ra of 2.0 nm or less, the inorganic thin film (4) being formed of at least one inorganic materials selected from ITO, Ti, Au, Ag, Al, Cr, Cu, Mg, Ti, Al₂O₃, MgO, Y₂O₃, La₂O₃, Pr₆O₁₁, Ss₂O₃, WO₃, HfO₂, In₂O₃, ZrO₂, Nd₂O₃, Ta₂O₅, CeO₂, Nb₂O₅, TiO, TiO₂, Ti₃O₅₅, NiO, and ZnO;
the glass film (2) has a surface roughness Ra of 2.0 nm or less at least at a surface of a laminate side; and
the glass film (2) is laminated on the inorganic thin film (4) in a state of the surface of the inorganic thin film (4) and the surface of the glass film (2) being in contact with each other.

4. The glass film laminate according to claim 3, wherein each of the surface of the laminate side of the glass film (2) and the surface of the inorganic thin film (4) has a GI value of 1000 pcs/m² or less.

5. The glass film laminate according to claim 3 or 4, wherein the glass film (2) has a thickness of 300 µm or less.

6. The glass film laminate according to any one of claims 3 to 5, wherein the supporting glass (3) has a thickness of 400 µm or more.

7. The glass film laminate according to any one of claims 3 to 6, wherein a difference in thermal expansion coefficients between the glass film (2) and the supporting glass (3) at 30 to 380°C falls within 5×10⁻⁷/°C.

8. The glass film laminate according to any one of claims 3 to 7, wherein each of the glass film (2) and the supporting glass (3) is formed by an overflow down-draw method.

## Patentansprüche

1. Verfahren zur Herstellung eines Glasfilms, umfassend:
einen ersten Schritt des Bildens eines anorganischen dünnen Films (4) auf einer Oberfläche eines Trägerglases (3), so dass eine Oberfläche des anorganischen dünnen Films (4) nach dem Ausbilden eine Oberflächenrauigkeit Ra von 2,0 nm oder weniger aufweist, wobei der anorganische dünne Film (4) aus wenigstens einem anorganischen Material gebildet ist, das aus ITO, Ti, Au, Ag, Al, Cr, Cu, Mg, Ti, Al₂O₃, MgO, Y₂O₃, La₂O₃, P_{F6}O₁₁, Ss₂O₃, WO₃, HfO₂, In₂O₃,ZrO₂, Nd₂O₃, Ta₂O₅,CeO₂,Nb₂O₅, TiO, TiO₂, Ti₃O₅, NiO und ZnO ausgewählt ist,
einen zweiten Schritt des Bildens eines Glasfilmlaminats (1) durch Laminieren eines Glasfilms (2) mit einer Oberflächenrauigkeit Ra von 2,0 nm oder weniger auf die Oberfläche des anorganischen dünnen Films (4) in einem Zustand, bei dem sie miteinander in Kontakt stehen,
einen dritten Schritt des Ausführens einer das Erwärmen beinhaltende Behandlung in Bezug auf das Glasfilmlaminat (1) und
einen vierten Schritt des Abziehens des Glasfilms (2) vom Trägerglas (3) nach der das Erwärmen beinhaltenden Behandlung.

2. Verfahren zur Herstellung eines Glasfilms nach Anspruch 1, wobei der Glasfilm (2) und das Trägerglas (3) so laminiert sind, dass wenigstens ein Teil eines Kantenabschnitts eine Stufe (5) enthält.

3. Glasfilmlaminat (1), umfassend ein Trägerglas (3) und einen Glasfilm (2), der auf dem Trägerglas (3) laminiert ist, wobei
ein anorganischer dünner Film (4) auf einer Oberfläche des Trägerglases (3) ausgebildet ist, auf welcher der Glasfilm (2) laminiert ist, so dass eine Oberfläche des anorganischen dünnen Films (4) nach dem Ausbilden eine Oberflächenrauigkeit Ra von 2,0 nm oder weniger aufweist, wobei der anorganische dünne Film (4) aus wenigstens einem anorganischen Material gebildet ist, das aus ITO, Ti, Au, Ag, Al, Cr, Cu, Mg, Ti, Al₂O₃, MgO, Y₂O₃, La₂O₃, Pr₆O₁₁, Ss₂O₃, WO₃, HfO₂, In₂O₃,ZrO₂, Nd₂O₃, Ta₂O₅,CeO₂,Nb₂O₅, TiO, TiO₂, Ti₃O₅, NiO und ZnO ausgewählt ist,
der Glasfilm (2) eine Oberflächenrauigkeit Ra von 2,0 nm oder weniger auf einer Oberfläche einer Laminatseite aufweist und
der Glasfilm (2) auf dem anorganischen dünnen Film (4) in einem Zustand laminiert ist, bei dem die Oberfläche des anorganischen dünnen Films (4) und die Oberfläche des Glasfilms (2) miteinander in Kontakt stehen.

4. Glasfilmlaminat nach Anspruch 3, wobei die Oberfläche der Laminatseite des Glasfilms (2) und die Oberfläche des anorganischen dünnen Films (4) jeweils einen GI-Wert von 1000 pcs/m² oder weniger aufweist.

5. Glasfilmlaminat nach Anspruch 3 oder 4, wobei der Glasfilm (2) eine Dicke von 300 µm oder weniger aufweist.

6. Glasfilmlaminat nach einem der Ansprüche 3 bis 5, wobei das Trägerglas (3) eine Dicke von 400 µm oder mehr aufweist.

7. Glasfilmlaminat nach einem der Ansprüche 3 bis 6, wobei ein Unterschied im thermischen Ausdehnungskoeffizienten zwischen dem Glasfilm (2) und dem Trägerglas (3) bei 30 bis 380 °C innerhalb 5×10⁻⁷/°C liegt.

8. Glasfilmlaminat (1) nach einem der Ansprüche 3 bis 7, wobei der Glasfilm (2) und das Trägerglas (3) jeweils durch ein Überlauf-Abzieh-Verfahren gebildet sind.

## Revendications

1. Procédé de production d'un film de verre, comprenant :
une première étape de formation d'un film inorganique fin (4) à la surface d'un verre de support (3) de sorte que la surface du film inorganique fin (4) présente après formation, une rugosité de surface Ra de 2,0 nm ou moins, le film inorganique fin (4) étant composé d'au moins un des matériaux inorganiques choisis parmi ITO, Ti, Au, Ag, Al, Cr, Cu, Mg, Ti, Al₂O₃, MgO, Y₂O₃, La₂O₃, Pr₆O₁₁, Ss₂O₃, WO₃, HfO₂, In₂O₃, ZrO₂, Nd₂O₃, Ta₂O₅, CeO₂, Nb₂O₅, TiO, TiO₂, Ti₃O₅, NiO et ZnO ;
une deuxième étape de formation d'un stratifié de film de verre (1) par stratification d'un film de verre (2) ayant une rugosité de surface Ra de 2,0 nm ou moins sur la surface du film inorganique fin (4) en état d'être mis en contact mutuel ;
une troisième étape de réalisation d'un traitement impliquant le chauffage du stratifié de film de verre (1) ; et
une quatrième étape de pelage du film de verre (2) depuis le verre de support (3) après le traitement comportant un chauffage.

2. Procédé de production d'un film de verre selon la revendication 1, dans lequel le film de verre (2) et le verre de support (3) sont stratifiés de sorte qu'au moins une partie d'une zone de bordure comprend une étape (5).

3. Stratifié de film de verre (1) comprenant un verre de support (3) et un film de verre (2) stratifié sur le verre de support (3), dans lequel
un film inorganique fin (4) est formé sur une surface, sur laquelle le film de verre (2) est stratifié, du verre de support (3) de sorte que la surface du film inorganique fin (4) présente après formation, une rugosité de surface Ra de 2,0 nm ou moins, le film inorganique fin (4) étant composé d'au moins un des matériaux inorganiques choisis parmi ITO, Ti, Au, Ag, Al, Cr, Cu, Mg, Ti, Al₂O₃, MgO, Y₂O₃, La₂O₃, Pr₆O₁₁, Ss₂O₃, WO₃, HfO₂, In₂O₃, ZrO₂, Nd₂O₃, Ta₂O₅, CeO₂, Nb₂O₅, TiO, TiO₂, Ti₃O₅, NiO et ZnO ;
le film de verre (2) a une rugosité de surface Ra de 2,0 nm ou moins sur au moins une surface d'un côté stratifié, et
le film de verre (2) est stratifié sur le film inorganique fin (4) de sorte que la surface du film inorganique fin (4) et la surface du film de verre (2) soient en contact l'une avec l'autre.

4. Stratifié de film de verre selon la revendication 3, dans lequel chacune de le surface du côté stratifié du film de verre (2) et de la surface du film inorganique fin (4) ont une valeur GI de 1000 pcs/m² ou moins.

5. Stratifié de film de verre selon la revendication 3 ou 4, dans lequel le film de verre (2) a une épaisseur de 300 µm ou moins.

6. Stratifié de film de verre selon l'une quelconque des revendications 3 à 5, dans lequel le verre de support (3) a une épaisseur de 400 µm ou plus.

7. Stratifié de film de verre selon l'une quelconque des revendications 3 à 6, dans lequel la différence des coefficients de dilatation thermique entre le film de verre (2) et le verre de support (3) de 30 à 380°C se situe à 5x10⁻⁷/°C.

8. Stratifié de film de verre selon l'une quelconque des revendications 3 à 7, dans lequel chacun du film de verre (2) et du verre de support (3) est formé par un procédé d'étirage par le bas par débordement.
